# EUROPEAN PATENT APPLICATION

(11) **EP 4 350 751 A1**
(43) Date of publication of application: **10.04.2024**
(21) Application number: 22803154.8
(22) Date of filing: 10.10.2022
(51) Int. Cl.: H01L 21/78, H01L 31/05

(54) **SOLAR CELL, MANUFACTURING METHOD, AND PHOTOVOLTAIC MODULE**

(30) Priority: 24.08.2022 CN 202211021116
(71) Applicant: Hengdian Group DMEGC Magnetics Co., Ltd., Dongyang, Zhejiang 322118 (CN)
(72) Inventor: The designation of the inventor has not yet been filed
(74) Representative: Petraz, Gilberto Luigi
(86) International application number: PCT/CN2022/124384
(87) International publication number: WO 2024/040704

(57) **Abstract**

A solar cell (I), a method of manufacturing the same, and a photovoltaic component (II) are provided. The method of manufacturing the solar cell includes: acquiring the solar cell (I) by dividing a cell sheet (10). An aspect ratio of the solar cell (I) is greater than 2 or less than 2, and a length of the solar cell (I) is the same as a dimension of the cell sheet (10) along a dividing direction.

## Description

### CROSS-REFERENCE TO RELATED APPLICATION

This application claims all benefits accruing from China Patent Application No. 202211021116.4, filed on August 24, 2022, titled "SOLAR CELL, METHOD OF MANUFACTURING THE SAME, AND PHOTOVOLTAIC COMPONENT" in the China National Intellectual Property Administration, the content of which is hereby incorporated by reference.

### TECHNICAL FIELD

The present invention generally relates to a technical field of semiconductor, and in particular, to a solar cell, a method of manufacturing the same, and a photovoltaic component.

### BACKGROUND

New energy is becoming more and more important in an energy field. New energy industry is constantly developing globally, and photovoltaic industry is an important part of the new energy industry.

Solar cells are core components of photovoltaic products, and the solar cells can make use of photovoltaic effect to convert light into electricity. The solar cells are made of semiconductor materials, such as silicon wafers. Solar cells of photovoltaic crystalline silicon are usually square silicon-based wafers, and corners of the square silicon-based wafers can have certain arcs. Because output power of a single solar cell is proportional to a size thereof, the single solar cell produced is getting greater and greater as maturity of the photovoltaic industry increases. At present, the solar cell made of silicon wafers with a side length of 182 mm or even greater has been rapidly promoted, and processing methods of the silicon wafers also needs to be matched.

As the size of the solar cell increases, efficiency thereof increases, but it also comes with many mismatches. At an application end, the size of photovoltaic components is getting greater and greater, resulting in a great increase in difficulty of manual operations. The size of large photovoltaic components is greatly different from that required in application scenarios. For example, the large-scale photovoltaic power stations and residential rooftop power stations have different requirements for the photovoltaic components. The large-scale photovoltaic power stations pay attention to power generation efficiency of the photovoltaic components, while the residential rooftop power stations pay more attention to power generation safety. As the size of the solar cell increases, an operation current also increases, which in turn comes with more serious risks of inverter matching, hot spots, and safety.

### SUMMARY

According to various embodiments of the present invention, a solar cell, a method of manufacturing the same, and a photovoltaic component are provided.

A method of manufacturing the solar cell is provided in an embodiment of the present invention. The method includes acquiring a solar cell by dividing a cell sheet, an aspect ratio of the solar cell is greater than 2 or less than 2, and a length of the solar cell is the same as a dimension of the cell sheet along a dividing direction.

In some embodiments, at least three solar cells can be acquired by dividing the cell sheet several times.

In some embodiments, the acquiring the solar cell by dividing the cell sheet includes acquiring a first solar cell, and a ratio of a width of the first solar cell to a length of the first solar cell is greater than 1/3 and less than 1/2.

In some embodiments, the dimension of the cell sheet is 182 mm×182 mm, and the acquiring the first solar cell includes acquiring the first solar cell with a width of 77±1 mm.

In some embodiments, the acquiring the solar cell by dividing the cell sheet includes acquiring a second solar cell, a ratio of a width of the second solar cell to a length of the second solar cell is greater than 1/2 and less than 2/3.

In some embodiments, the dimension of the cell sheet has is 182 mm×182 mm, and the acquiring the second solar cell includes acquiring the second solar cell with a width of 105±1 mm.

In some embodiments, the cell sheet includes a semiconductor structure and a gate line in ohmic contact with the semiconductor structure, and the dividing the cell sheet includes dividing the cell sheet along an extending direction of the gate line, or along a direction perpendicular to the extending direction of the gate line.

A method of manufacturing the photovoltaic component is provided in an embodiment of the present invention. The method of manufacturing the photovoltaic component includes acquiring a string of batteries by at least two solar cells connected in series, and an aspect ratio of the solar cell is greater than 2 or less than 2. In some embodiments, the method of manufacturing the photovoltaic component further includes acquiring a battery module including a pass element and at least one string of batteries, and the pass element is connected in parallel with the at least one string of batteries.

In some embodiments, the method of manufacturing the photovoltaic component further includes steps of the method of manufacturing the solar cell.

In some embodiments, a step of acquiring a battery queue includes arranging at least two solar cells along the direction of the gate line thereof. A ratio of a width of each of the at least two solar cells to a length of corresponding one of the at least two solar cells is greater than 1/3 and less than 1/2.

In some embodiments, the step of acquiring the battery queue includes arranging at least two solar cells along the direction of the gate line thereof. The ratio of the width of each of the at least two solar cells to the length of corresponding one of the at least two solar cells is greater than 1/2 and less than 2/3.

In some embodiments, the direction of the gate line of each of the at least two solar cells is along a direction of the width of corresponding one of the at least two solar cells. The battery queue includes eleven solar cells, and the string of batteries includes two battery queues. The photovoltaic component includes three battery modules, and each of the three battery modules includes two strings of batteries. In some embodiments, the eleven solar cells include solar cells with a specification of narrow dimension and an aspect ratio greater than 2.

In some embodiments, the direction of the gate line of each of the at least two solar cells is along the direction of the width of corresponding one of the at least two solar cells. The battery queue includes eleven solar cells, and the string of batteries includes two battery queues. The photovoltaic component includes three battery modules, and each of the three battery modules includes two strings of batteries. In some embodiments, the eleven solar cells include solar cells with a specification of large size and an aspect ratio less than 2.

In some embodiments, the direction of the gate line of each of the at least two solar cells is along the direction of the width of corresponding one of the at least two solar cells. The battery queue includes eight solar cells, and the string of batteries includes two battery queues. The photovoltaic component includes three battery modules, and each of the three battery modules includes two strings of batteries.

In some embodiments, the direction of the gate line of each of the at least two solar cells is along a direction of the length of corresponding one of the at least two solar cells. The battery queue includes six solar cells, the string of batteries includes two battery queues spaced apart, and the photovoltaic component includes one string of batteries.

A solar cell is provided in an embodiment of the present invention. A ratio of a width of the solar cell to a length of the solar cell is greater than 1/2 or less than 1/2.

In some embodiments, the width of the solar cell denoted as L and the length of the solar cell denoted as D meet the following formula: 1/3<L/D<2/3, and L/D≠1/2.

In some embodiments, the length of the solar cell is 182 mm, and the width of the solar cell is 77±1 mm or 105±1 mm.

A photovoltaic component is provided in an embodiment of the present invention. The photovoltaic component includes at least one string of batteries, which includes at least two solar cells connected in series, and a ratio of a width of each of the at least two solar cells to a length of corresponding one of the at least two solar cells is greater than 1/2 or less than 1/2.

In this way, the solar cells are provided to ensure the photovoltaic component higher safety in use, a wide application range of installation, and better space utilization efficiency compared to a related photovoltaic component including half-chip cells.

In some embodiments, the photovoltaic component further includes a pass element, and the pass element and the string of batteries are connected in parallel with each other.

In some embodiments, the ratio of the width of each of the at least two solar cells to the length of corresponding one of the at least two solar cells is greater than 1/3 and less than 1/2.

In some embodiments, the length of each of the at least two solar cells is 182 mm, the width of corresponding one of the at least two solar cells is 77±1 mm, and a direction of a gate line of each of the at least two solar cells is along a direction of the width of corresponding one of the at least two solar cells. The at least one string of batteries includes at least two battery queues arranged in parallel, and each of the at least two battery queues includes at least two solar cells arranged along the direction of the gate line.

In some embodiments, the ratio of the width of each of the at least two solar cells to the length of corresponding one of the at least two solar cells is greater than 1/2 and less than 2/3.

In some embodiments, the length of each of the at least two solar cells is 182 mm, the width of corresponding one of the at least two solar cells is 105±1 mm, and a direction of a gate line of each of the at least two solar cells is along a direction of the width of corresponding one of the at least two solar cells. The at least one string of batteries includes at least two battery queues arranged in parallel, and each of the at least two battery queues includes at least two solar cells arranged along the direction of the gate line.

In some embodiments, each of the at least two battery queues includes eleven solar cells, the at least one string of batteries includes two battery queues, two strings of batteries connected in parallel with each other are defined as a battery module, and the photovoltaic component includes three battery modules arranged in parallel and connected in series.

In some embodiments, each of the at least two battery queues includes eight solar cells, the at least one string of batteries includes two battery queues, two strings of batteries connected in parallel with each other are defined as a battery module, and the photovoltaic component includes three battery modules arranged in parallel and connected in series.

In some embodiments, the length of each of the at least two solar cells is 182 mm, the width of corresponding one of the at least two solar cells is 105±1 mm, and the direction of the gate line of each of the at least two solar cells is along a direction of the length of corresponding one of the at least two solar cells. The at least one string of batteries includes at least two battery queues arranged in parallel and spaced apart, each of the at least two battery queues includes six solar cells, and the photovoltaic component includes one string of batteries.

The details of one or more embodiments of the present invention are set forth in the accompanying drawings and the description below. Other features, objects and advantages of the present invention will become apparent from the description, drawings and claims.

### BRIEF DESCRIPTION OF THE DRAWINGS

In order to better describe and explain the embodiments and/or examples of those inventions disclosed herein, one or more drawings may be referred to. The additional details or examples used to describe the drawings should not be considered as limiting the scope of any of the disclosed inventions, the currently described embodiments and/or examples, and the best mode of these inventions currently understood.
FIG. 1 is a structural schematic view of a cell sheet in a comparative example of a related art.
FIG. 2 is a flow block view of a method of manufacturing a solar cell in one or more embodiments of the present invention.
FIG. 3 is a flow block view of another method of manufacturing a solar cell in one or more embodiments of the present invention.
FIG. 4 is a structural schematic view of a cell sheet in one or more embodiments of the present invention.
FIG. 5 is a structural schematic view of another cell sheet in one or more embodiments of the present invention.
FIG. 6 is a flow block view of a method of manufacturing a photovoltaic component in one or more embodiments of the present invention.
FIG. 7 is a flow block view of another method of manufacturing a photovoltaic component in one or more embodiments of the present invention.
FIG. 8 is a structural schematic view of a battery queue in one or more embodiments of the present invention.
FIG. 9 is a structural schematic view of a string of batteries in one or more embodiments of the present invention.
FIG. 10 is a structural schematic view of a photovoltaic component in one or more embodiments of the present invention.
FIG. 11 is a circuit schematic view of a photovoltaic component in one or more embodiments of the present invention.
FIG. 12 is a schematic view of a packaging box in a stacking state in one or more embodiments of the present invention.
FIG. 13 is a structural schematic view of another photovoltaic component in one or more embodiments of the present invention.
FIG. 14 is a structural schematic view of another photovoltaic component in one or more embodiments of the present invention.
FIG. 15 is a structural schematic view of another photovoltaic component in one or more embodiments of the present invention.

In the figures, 10 represents a cell sheet, 100 represents a semiconductor structure, 200 represents a gate line, I represents a solar cell, 1 represents a first solar cell, 101 represents a first gate line, 2 represents a second solar cell, 201 represents a second gate line, 3 represents a battery queue, 30 represents a string of batteries, 31 represents a first battery queue, 32 represents a second battery queue, 301 represents a conductive connection wire, II represents a photovoltaic component, 40 represents a pass element, 50 represents a battery module, 4 represents a first photovoltaic component, 41 represents a first backplane, 420 represents a first power transmission line, 421 represents a first pass element, 43 represents a first cell component, 431 represents a first string of batteries of the first cell component, 432 represents a second string of batteries of the first cell component, 433 represents a third string of batteries of the first cell component, 44 represents a first battery module, 5 represents a container, 51 represents a packaging box, 6 represents a second photovoltaic component, 61 represents a second backplane, 620 represents a second power transmission line, 621 represents a second pass element, 63 represents a second cell component, 631 represents a first string of batteries of the second cell component, 632 represents a second string of batteries of the second cell component, 633 represents a third string of batteries of a second cell component, 64 represents a second battery module, 7 represents a third photovoltaic component, 71 represents a third backplane, 720 represents a third power transmission line, 721 represents a third pass element, 73 represents a third cell component, 731 represents a first string of batteries of the third cell component, 732 represents a second string of batteries of the third cell component, 733 represents a third string of batteries of the third cell component, 74 represents a third battery module, 8 represents a fourth photovoltaic component, 81 represents a fourth backplane, 820 represents a fourth power transmission line, 831 represents a string of batteries of a fourth cell component, and 83 represents the fourth cell component.

### DETAILED DESCRIPTION

Hereinafter, the technical solutions in the embodiments of the present invention will be clearly and completely described with reference to the accompanying drawings in the embodiments of the present invention. Obviously, the described embodiments are merely a part of the embodiments of the present invention, rather than all of the embodiments. Based on the embodiments of the present invention, all other embodiments obtained by one skilled in the art without creative efforts all belong to the scope of protection of the present invention.

It should be noted that when an element is referred to as being "set" on another element, it may be directly set on the other element or a further element may be presented between them. When an element is considered to be "disposed" on another element, it may be directly disposed on the other element or a further element may be presented between them. When an element is referred to as being "fixed" to another element, it may be directly fixed to the other element or a further element may be presented between them.

The structural dimensions shown in the accompanying drawings in this invention do not represent actual dimensions, and may be adjusted as needed during actual production. The orientation words "up", "down", "left", "right", etc. used in this invention refer to orientations in the drawings and should not be regarded as limitations on the actual use of the product unless explicitly stated.

First, second, third, etc. in this invention are used only to distinguish the same features, and it is understood that a first solar cell in this invention may also be referred to as a second solar cell and the second solar cell may also be referred to as the first solar cell.

Unless otherwise defined, all technical and scientific terms used herein have the same meaning as one skilled in the art would understand. The terminology used in the description of the present invention is for the purpose of describing particular embodiments and is not intended to limit the invention. For example, the terms "series" and "parallel" used in the present invention are for the purpose of describing forms of electrical connections, and not restrictions on mechanical construction. As used herein, the term "or/and" includes any and all combinations of one or more related listed items.

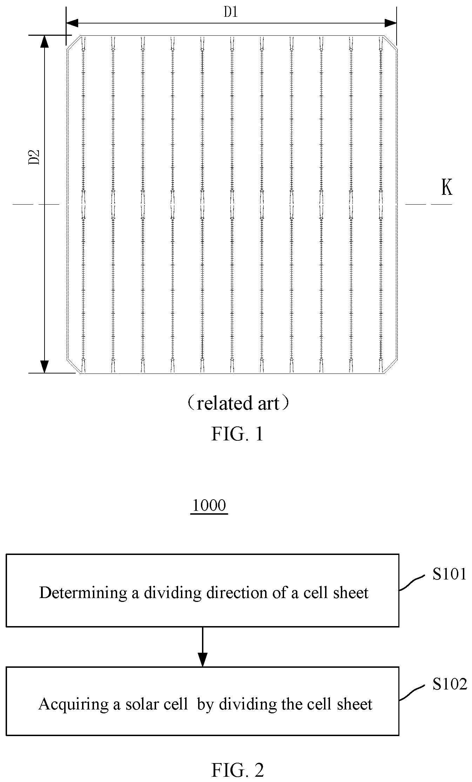

FIG. 1 is a structural schematic view of a cell sheet in a comparative example of a related art. Referring to FIG. 1, a length of the cell sheet denoted as D1and a width of the cell sheet denoted as D2 can be the same, for example, a dimension of the cell sheet can be 182 mm×182 mm. When dividing the cell sheet, the cell sheet can be divided into two half-chip cells along a dividing line denoted as K, and a dimension of each of the half-chip cells can be 182 mm×91 mm, i.e. an aspect ratio of 2. The dimension of the cell sheet in the related art has been provided from 156.75 mm, 158.75 mm, and 166 mm to a large dimension such as 182 mm or 210 mm. However, an application of the half-chip cells with the dimension of 182 mm×91 mm or 210 mm×105 mm has certain restrictions, and operation efficiency of the half-chip cells hits a certain bottleneck. At a logistics end, problems such as mismatch, and increased difficulty in packaging and transshipment are existed between large-dimension photovoltaic components and containers. An impact is even greater at a manufacturing end, and an entire industry chain needs to be upgraded or replaced. Whether at a material end involving silicon rods and wafers, or at a middle end involving cell and module preparation, many near-new devices are at risk of being eliminated.

It should be noted that, unless otherwise defined, according to various embodiments in the present invention, the length can be a dimension along an X-axis direction, and the width can be a dimension along a Y-axis direction.

Referring to FIG. 2, a method 1000 of manufacturing a solar cell 100 is provided in embodiments of the present invention, and the method 1000 can include steps described below.

In some embodiments, step 101 can include: determining a dividing direction of a cell sheet 10. It can be understood that the cell sheet 10 is thin, and the dividing direction refers to a certain direction within a light-facing surface of the cell sheet 10.

Step 102 can include: acquiring a solar cell I by dividing the cell sheet 10. A length of the solar cell I is the same as a dimension of the cell sheet 10 along the dividing direction, and an aspect ratio of the solar cell I is greater than 2 or less than 2. In some embodiments, the cell sheet 10 can be divided along the determined dividing direction, and dividing methods can include laser cutting, or other cutting methods, such as mechanical cutting including waterjet methods.

In this way, the solar cell I can be acquired by an asymmetric dividing method. The solar cell I has smaller resistance than the cell original 10, a smaller current in a circuit, and a width that is not half of the length of the solar cell I. The solar cell I can be suitable for splicing a photovoltaic component II in a different dimension compared to the half-chip cells with the aspect ratio of 2, which can better reconcile an actual difference between the solar cell I divided from the cell sheet 10 and solar cells required at an application end. Efficiency potential or cost space of the solar cell I can be excavated. The resistance and current of the solar cell I are both less than those of a square cell sheet 10, and the solar cell I is configured to form a photovoltaic component II in a variety of dimensions with better performance and better cost performance in production, transportation, installation, and use.

The asymmetric dividing of the cell sheet 10 can be realized by the method of manufacturing the solar cell provided in the embodiment of the present invention, so as to acquire the solar cell I which is smaller than the cell sheet 10. The solar cell I can be better adapted to the application end compared to the cell sheet 10 with a large-dimension, and has higher power generation efficiency than that of the half-sheet cells. In addition, in the method of manufacturing the solar cell, conventional production lines can be used to manufacture the solar cell I as much as possible, and it is easier to modify the production lines, thus improving flexible production capacity of the production line. The solar cell I can be adapted to actual situations of a raw material end and the application end by arranging the aspect ratio, and achieve small current and small resistance.

In some embodiments, the cell sheet 10 can be divided into two pieces or multiple pieces, such as three pieces, four pieces, or other pieces not more than twenty. Exemplarily, at least three solar cells I can be acquired by dividing the cell sheet 10 several times. In an aspect, the length of the solar cell I can be the same as a dimension of the cell sheet 10 along the dividing direction, but it does not exclude possibility of continuing dividing to change a dimension of the solar cell I. In another aspect, the length and the width of the cell sheet 10 can also be other dimensions.

In an embodiment, the acquiring the solar cell I by dividing the cell sheet includes acquiring a first solar cell. A ratio of a width of the first solar cell to a length of the first solar cell is greater than 1/3 and less than 1/2. In this way, the first solar cell smaller than the half-chip cell can be acquired. The step facilitates acquiring two solar cells I smaller than the half-chip cells, or second solar cells larger than the half-chip cells. The smaller solar cell I can be configured to form a string of batteries, which has better performance and a neat and compact structure.

In an embodiment, the acquiring the solar cell I by dividing the cell sheet can include acquiring a second solar cell. A ratio of a width of the second solar cell to a length of the second solar cell is greater than 1/2 and less than 2/3. In this way, the second solar cell larger than the half-chip cell can be acquired, and the step facilitates acquiring the solar cell I with small dimension. The larger solar cell I can be configured to form a string of batteries, which has better performance. The dimension of the string of batteries can be adjusted based on the number of the solar cell I, and a cathode and an anode of the string of batteries are located at the same side to implement a transmission circuit.

Two first solar cells, or one first solar cell and one second solar cell can be acquired by dividing one cell sheet 10. The first solar cell and the second solar cell can be acquired separately or synchronously. The method of manufacturing the solar cell is more efficient when the first solar cell and the second solar cell are acquired simultaneously.

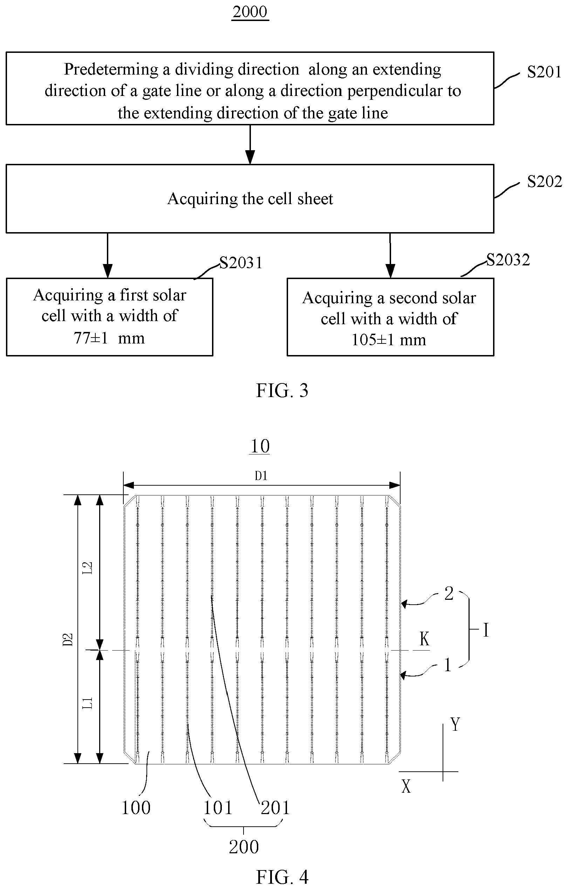

Referring to FIG. 3, a method 2000 of manufacturing a solar cell is provided in an embodiment of the present invention, and the method 2000 can include steps described below.
Step 201 can include predeterming a dividing direction along an extending direction of a gate line or along a direction perpendicular to the extending direction of the gate line. Step 202 includes acquiring the cell sheet.
Specifically, a cathode and an anode of the cell sheet can be away from dividing positions according to the predetermined dividing direction and the dividing positions.

In an embodiment, step 203 can include acquiring the solar cell I. The step 203 can include the following steps: at step 2031, acquiring a first solar cell with a width of 77±1 mm; at step 2032, acquiring a second solar cell with a width of 105±1 mm. The step 2031 and the step 2032 can be performed synchronously or separately. The first solar cell with the width in the range of 76 mm to 78 mm and the second solar cell with the width in the range of 104 mm to 106 mm both have good performance, and the efficiency potential of the solar cell I can be excavated, so as to realize the application at the application end.

FIG. 4 illustrates a cell sheet provided in an embodiment of the present invention, which can be acquired by the step 202 mentioned above. The cell sheet 10 can include a semiconductor structure 100 and a gate line 200 in ohmic contact with the semiconductor structure 100. Specifically, the gate line 200 of the cell sheet 10 can include a first gate line 101 and a second gate line 201, which both extend along a Y-axis direction.

Referring to FIG. 4, the dimension D1 of the cell sheet 10 along an X-axis direction is the same as the dimension D2 thereof along the Y-axis direction. The preset dividing line K of the cell sheet 10 can be along the X-axis direction, that is, roughly perpendicular to the Y-axis direction. Along the Y-axis direction, a distance between the dividing line K and one side of the cell sheet 10 denoted as L1 and a distance between the dividing line K and another side of the cell sheet 10 denoted as L2 can be different, specifically, L2 > L1. A cathode and an anode of the gate line 200 can be away from the dividing line K.

The method of manufacturing the solar cell provided in an embodiment of the present invention can include: acquiring a first solar cell 1 and a second solar cell 2 by dividing the cell sheet 10 along the preset dividing line K.

Both a length of the first solar cell 1 and a length of the second solar cell 2 provided in the embodiment of the present invention are equal to the dimension D1 of the cell sheet 10 along a direction of the dividing line K. Specifically, the ratio of the width L1 of the first solar cell 1 to the length D1 of the first solar cell 1 can meet the following formula: 1/3 <L1/D1 < 1/2, and the ratio of the width L2 of the second solar cell 2 to the length D2 of the second solar cell 2 can meet the following formula: 1/2 < L2/D2<2/3. In this way, strength of the solar cell I can be better ensured, and the resistance and the current of the solar cell I can be controlled to applied in the transmission circuit. In addition, the extending direction of the first gate line 101 can be along a width direction of the first solar cell 1, and the extending direction of the second gate line 201 can be along a width direction of the second solar cell 2.

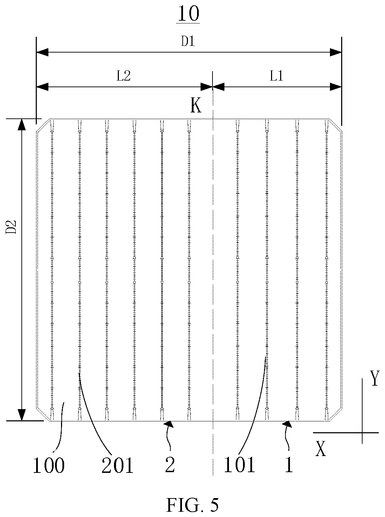

FIG. 5 illustrates a cell sheet provided in an embodiment of the present invention, which can be acquired by the step 202 mentioned above. The cell sheet 10 can include a semiconductor structure 100 and a gate line 200 in ohmic contact with the semiconductor structure 100. Specifically, the gate line 200 of the cell sheet 10 can include a first gate line 101 and a second gate line 201, which both extend along the Y-axis direction.

The dividing the cell sheet can include dividing the cell sheet along an extending direction of the gate line, or along a direction perpendicular to the extending direction of the gate line. In this way, the solar cell I can be acquired by dividing the cell sheet, and the extending direction of the gate line 200 of the solar cell I can be along the width direction or possibly along the length direction thereof, so as to realize a corresponding arrangement for different application environments of the solar cell I.

The method of manufacturing the solar cell provided in an embodiment of the present invention can include: acquiring a first solar cell 1 and a second solar cell 2 by dividing the cell sheet 10 along the preset dividing line K. Both the length of the first solar cell 1 and the length of the second solar cell 2 provided in the embodiment of the present invention are equal to the dimension D2 of the cell sheet 10 along a direction of the dividing line K. Specifically, the ratio of the width L1 of the first solar cell 1 to the length D1 of the first solar cell 1 can meet the following formula: 1/3<L1/D1 < 1/2, and the ratio of the width L2 of the second solar cell 2 to the length D2 of the second solar cell 2 can meet the following formula: 1/2 < L2/D2 < 2/3. In addition, the extending direction of the first gate line 101 can be along a length direction of the first solar cell 1, and the extending direction of the second gate line 201 can be along a length direction of the second solar cell 2.

In an embodiment, the dimension of the cell sheet 10 can be 182 mm×182 mm, and the step 2031 can include acquiring the first solar cell 1 with the width L1 of 77±1 mm. In this way, the dimension of the acquired solar cell I can be smaller, and the photovoltaic component II can be formed by the first solar cell 1 with the dimension of about 77 mm, so as to achieve a suitable overall dimension and power. Therefore, it facilitates acquiring the solar cell I with a small dimension and good performance, and the solar cell I can be suitable for forming a high-performance photovoltaic component II. Step 2032 can include acquiring the second solar cell 2 with the width L2 of 105±1 mm. In this way, the dimension of the acquired solar cell I can be larger, the power can be greater, space utilization can be higher, and the photovoltaic component II can be formed by the second solar cell 2 with the dimension of about 105 mm, so as to achieve a suitable overall dimension and power. Therefore, it facilitates acquiring the solar cell I with a large dimension, sufficient space utilization and excellent performance. In some other embodiments, the step 2031 can include acquiring the first solar cell 1 with the width L1 of 82±1 mm, and the step 2032 can include acquiring the second solar cell 2 with the width L2 of 100±1 mm. In short, the ratio of the width of the first solar cell 1 to the length of the first solar cell 1 can be greater than 1/2 or less than 1/2, and the ratio of the width of the second solar cell 2 to the length of the second solar cell 2 can be greater than 1/2 or less than 1/2.

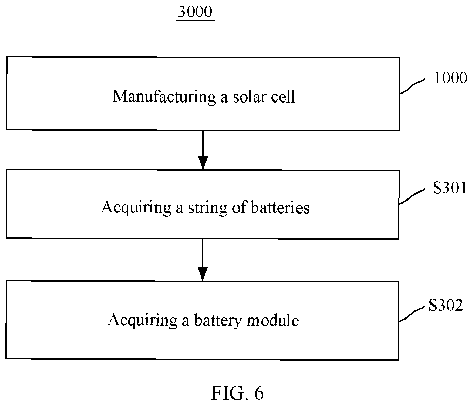

Referring to FIG. 6, a method 3000 of manufacturing the photovoltaic component is provided in an embodiment of the present invention, and the method 3000 can include steps described below.

Step 301 can include acquiring a string of batteries. The string of batteries can include at least two solar cells I connected in series, and an aspect ratio of the solar cell I can be greater than 2 or less than 2.

In an embodiment, step 302 can include acquiring a battery module including a pass element and at least one string of batteries. Specifically, the at least one string of batteries can be provided on a backplane. The pass element 40 can be located at a side of the backplane away from the at least one string of batteries, and be electrically connected to the at least one string of batteries via a power line. The pass element 40 is configured to short-circuit a corresponding string of batteries when the corresponding string of batteries is not in operation. In this way, the pass element 40 is configured to pass current when the corresponding string of batteries is not in operation, and short-circuit the corresponding string of batteries connected in parallel with the pass element 40, ensuring that an overall circuit of the photovoltaic component II can be in operation.

In this way, the solar cells I are provided to ensure the photovoltaic component II higher safety in use, a wide application range of installation, and better space utilization efficiency compared to a related photovoltaic component including half-chip cells. The solar cells I with an aspect ratio greater than 2 or less than 2 can be used to splice the string of batteries with optimized aspect dimensions, so as to form the photovoltaic component II with at least one of beneficial effects of optimized dimensions, high efficiency, or easy transportation and installation.

In some embodiments, the method 3000 can further include a method of manufacturing a solar cell, such as the method 1000 of manufacturing the solar cell. The solar cells I can be first manufactured with the aspect ratio greater than 2 or less than 2, and then the string of batteries can be formed by the solar cells I.

The string of batteries can be formed by the solar cells I with the aspect ratio greater than 2 or less than 2 in an embodiment of the present invention. The string of batteries can be more suitable for an actual application environment, so that the efficiency of the photovoltaic component II can be closer to an ultimate utilization rate in the application environment.

The method of manufacturing the photovoltaic component provided in the present invention can solve problems that efficiency loss or performance imbalance caused by the difference between the dimension of the cell sheet and that in assembly requirements of the photovoltaic component. Therefore, the photovoltaic component can adapt precisely to the dimension in assembly requirements, and has higher power and better cost performance in transportation and installation.

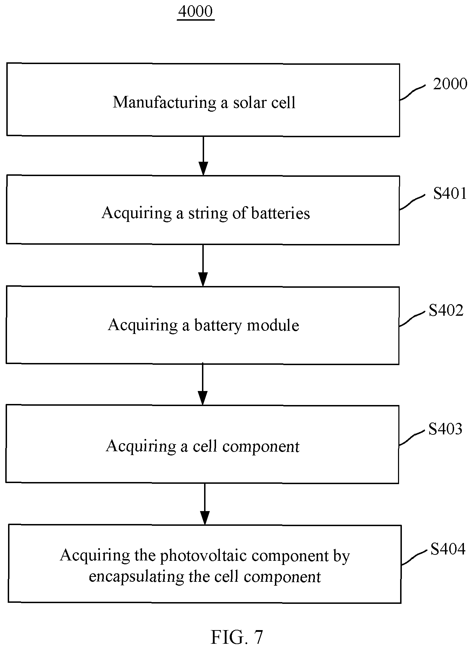

Referring to FIG. 7, a method 4000 of manufacturing the photovoltaic component is provided in an embodiment of the present invention, and the method 4000 can include steps described below.

Step 401 can include acquiring a string of batteries. The string of batteries can include at least two solar cells I connected in series. In an embodiment, the acquiring the string of batteries can include acquiring at least two battery queues arranged in parallel, and each of the battery queues can include at least one solar cell I. In an embodiment, the acquiring at least two battery queues arranged in parallel can include arranging at least two solar cells I along the direction of the gate line 200 thereof. In this way, the string of batteries has the neat and compact structure, and the cathode and the anode thereof can be located at the same side to implement a transmission circuit.

Step 402 can include acquiring a battery module. Specifically, the battery module 50 can be acquired by the string of batteries and the pass element electrically connected in parallel with each other. In an embodiment, the battery module 50 can include a pass element and at least one string of batteries.

In some embodiments, the method of manufacturing the photovoltaic component can further include acquiring at least two battery modules 50 arranged in parallel and connected in series. In this way, a row of the battery modules 50 can supply power to a linear power transmission line, and the dimension and quantity of the battery modules 50 arranged in parallel can be controlled to meet the requirements, thus ensuring the dimension of the photovoltaic component II.

Step 403 can include acquiring a cell component. Alternatively, the cell component can include a battery module.

A cell array can include at least one row of the strings of batteries. Alternatively, the row of the strings of batteries can be formed by three strings of batteries arranged in parallel. In some embodiments, a formation of the string of batteries can be considered to be a simultaneous formation of the last battery queue therein, and a formation of the cell array can be considered to be a simultaneous formation of the last string of batteries therein.

In some embodiments, the method 4000 can further include a method of manufacturing a solar cell. The solar cell I can be first manufactured with the aspect ratio greater than 2 or less than 2 by the method, and then the string of batteries can be formed by the manufactured solar cell I.

In this way, the smaller solar cell I can be used to form the string of batteries, which has better performance and the neat and compact structure. The cell sheet can be effectively used to manufacture the photovoltaic component II, and the solar cell I can facilitate forming a variety of photovoltaic component II.

In an embodiment, the method 4000 can further include: at step 404, acquiring the photovoltaic component II by encapsulating the cell component. The photovoltaic component II can include only one cell component.

Alternatively, the battery queue can include eleven solar cells I, and the string of batteries can include two battery queues. The row of the strings of batteries can include three strings of batteries arranged in parallel, and the cell array can include two rows of the strings of batteries.

In this way, the cell array can include one hundred and thirty-two solar cells I, and when the dimension of the solar cell I is 182 mm×77 mm, the dimension of the photovoltaic component II can be changed to 1770 mm in length and 1134 mm in width, which provides suitable output voltage and lower current in operation with a smaller dimension. Moreover, the photovoltaic component II can be easy to manufacture and mount, and can be safer to use.

In this way, the cell array can include one hundred and thirty-two solar cells I, and when the dimension of the solar cell I is 182 mm×105 mm, the photovoltaic component II has high efficiency and strong power generation performance. The photovoltaic component II can make full use of transportation space and transportation capacity, thus ensuring higher overall efficiency.

In an embodiment, the one hundred and thirty-two solar cells I can include solar cells I with a specification of narrow dimension that the aspect ratio is greater than 2. In this way, the cell array can include one hundred and thirty-two solar cells I, and a high-power and high-efficiency solar power generation can be realized by the suitable solar cell I. In an embodiment, the one hundred and thirty-two solar cells I can include solar cells I with a specification of large dimension that the aspect ratio is less than 2. In this way, the photovoltaic component II with high cost performance in transportation can be acquired, and total power of the product transported by capacity of a single container can be enhanced in an international trade.

Alternatively, the battery queue can include eight solar cells I, and the string of batteries can include two battery queues. The row of the strings of batteries can include three strings of batteries arranged in parallel, and the cell array can include two rows of the strings of batteries. A direction of the gate line 200 of each of the solar cells I can be along a direction of the width of corresponding one of the solar cells I. In this way, a suitable-dimension photovoltaic component II can be formed by a large-dimension solar cell I, so as to adapt to the same packaging process as the photovoltaic component II formed by a small-dimension solar cell I, and then the photovoltaic component II with high packaging cost performance can be formed.

In this way, the cell array can include ninety-six solar cell I, and the cell array has a smaller dimension, realizing flexible assembly and application of the solar cells. The photovoltaic component II can have a similar dimension to the photovoltaic component II formed by the small-dimension solar cell, the photovoltaic component II formed by the large-dimension solar cell and the photovoltaic component II formed by the small-dimension solar cell can adapt to the same packaging process, and then the photovoltaic component II with high packaging cost performance can be formed.

Alternatively, the battery queue can include six solar cells I with the gate line 200 deposed along the length direction of the solar cell I, the string of batteries can include two battery queues spaced apart and connected in series, and the string of batteries can be packaged into the photovoltaic component II. The extending direction of the gate line 200 of the solar cell I can be along the length direction of the solar cell I. In this way, the photovoltaic component II with a narrow form can be acquired, which is suitable to mount in mounting space which is narrow and configured for light transmission.

It should be noted that the first solar cell 1 and the second solar cell 2 provided in the present embodiments can be used separately.

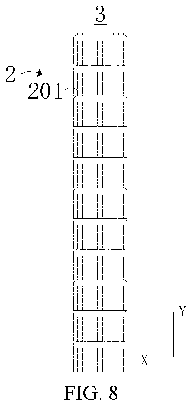

The photovoltaic component II provided in the present embodiment can include a battery queue 3 as shown in FIG. 8. Referring to FIG. 8, the battery queue 3 can include at least one second solar cell 2, the second gate line 201 of the second solar cell 2 can be along the width direction of the second solar cell 2, and at least two second solar cells 2 are connected in series along the extending direction of the second gate line 201. In an embodiment, the battery queue 3 can include eleven second solar cells 2. The battery queue 3 is configured to form the string of batteries, and the battery queue 3 is also configured to supply power for the photovoltaic component II separately.

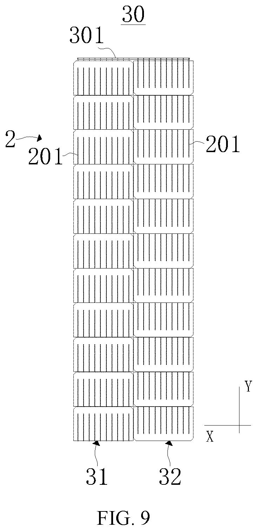

The photovoltaic component II provided in the present embodiment can include a string of batteries 30 as shown in FIG. 9. Referring to FIG. 9, the string of batteries 30 can include two battery queues, i.e., a first battery queue 31 and a second battery queue 32, respectively. Referring to FIG. 9, the first battery queue 31 and the second battery queue 32 can include eleven second solar cells 2 respectively, which are placed along the extending direction of the second gate line 201, i.e., the Y-axis direction shown in FIG. 9. The first battery queue 31 and the second battery queue 32 can be arranged in parallel along the X-axis direction and be opposite along the Y axis direction. That is, a cathode of the first battery queue 31 can be electrically connected to an anode of the second battery queue 32. The photovoltaic component II can include a conductive connection wire 301, and the first battery queue 31 can be electrically connected to the second battery queue 32 via the conductive connection wire 301. Referring to FIG. 9, the conductive connection wire 301 can be located at an upper side, and the cathode and the anode of the string of batteries 30 can be located at a lower side. In an embodiment, the string of batteries 30 can include twenty-two second solar cells 2. The string of batteries 30 is configured to form the cell component, and the string of batteries 30 is also configured to supply power for the photovoltaic component II separately.

In an embodiment, the string of batteries 30 can include two battery queues, each of the battery queues can include only one second solar cell 2.

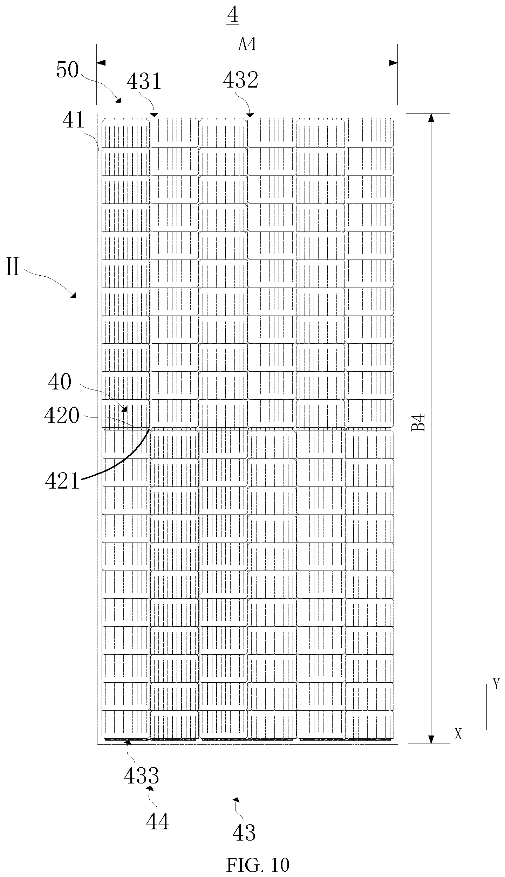

A photovoltaic component II is provided by an embodiment of the present invention in FIG. 10. Referring to FIG. 10, a first photovoltaic component 4 provided in the embodiment of the present invention can include a first power transmission line 420 and a first cell component 43, and the first cell component 43 can be electrically connected to the first power transmission line 420 to ensure power supply capability of the first photovoltaic component 4.

The first cell component 43 can include three battery modules 50, each of the three battery modules 50 can include two strings of batteries connected in parallel, and the pass element 40 connected in parallel with the two strings of batteries. That is, the first cell component 43 can include six strings of batteries, and three pass elements 40 connected in series via the first power transmission line 420. Specifically, the first cell component 43 can include two rows of strings of batteries arranged opposite to each other along the Y-axis direction, and each of the two rows of strings of batteries can include three strings of batteries arranged in parallel along the X-axis direction. Referring to FIG. 10, the first string of batteries 431 of the first cell component and the second string of batteries 432 of the first cell component can be arranged in parallel along the X-axis direction, the first string of batteries 431 of the first cell component and the third string of batteries 433 of the first cell component can be arranged in parallel along the Y-axis direction, and the first power transmission line 420 can be located between the two rows of strings of batteries.

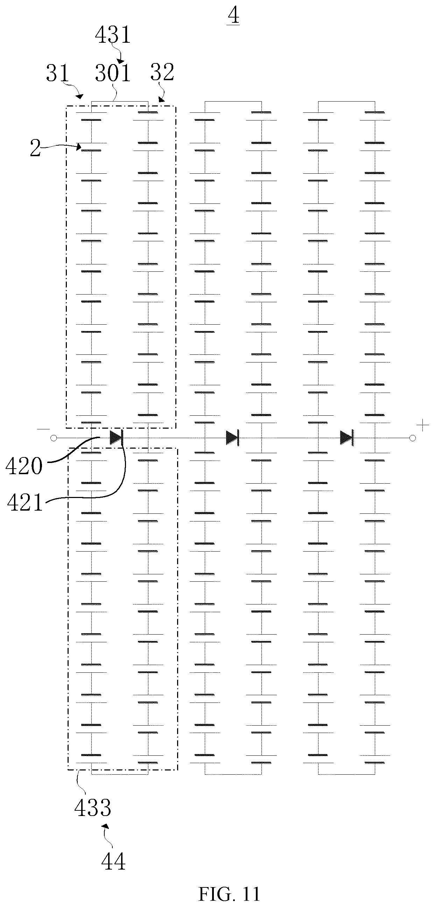

Referring to FIG. 11, the first power transmission line 420 can include a first pass element 421. In an embodiment, the first pass element 421 can include at least one semiconductor diode. When the first string of batteries 431 of the first cell component fails, the first pass element 421 can ensure that current transmitted by the first power transmission line 420 can flow from a negative terminal on the left side to a positive terminal on the right side. Each string of batteries can be connected in parallel with the corresponding first pass element 421. The first string of batteries 431 of the first cell component, the third string of batteries 433 of the first cell component and the first pass element 421 therebetween can be defined as the first battery module 44. The first cell component 43 can include three battery modules 50. The first power transmission line 420 can include a first bus bar connected to the first pass element 421, and the first bus bar can be connected to ends of a plurality of strings of batteries, so as to pool current to supply power to the outside world.

In an embodiment, the first string of batteries 431 of the first cell component can include the first battery queue 31 and the second battery queue 32, and the cathode of the first battery queue 31 can be electrically connected to the anode of the second battery queue 32 via the conductive connection wire 301. In the first cell component 43, the current of the string of batteries can flow to the positive terminal of the first power transmission line 420 to supply power to the first power transmission line 420, so that the first power transmission line 420 can supply power to external devices connected to the first photovoltaic component 4.

In an embodiment, the solar cell in the first cell component 43 can be the second solar cell 2 described above. Specifically, the extending direction of the gate line 200 can be along the width direction of the second solar cell 2. In an embodiment, the battery queue of each string of batteries in the first cell component 43 can include eleven second solar cells 2, the first cell component 43 can include three first battery modules 44, and the cell array of the first cell component 43 can include one hundred and thirty-two second solar cells 2. In an embodiment, the length of the second solar cell 2 can be 182 mm and the width of the second solar cell 2 can be 105 mm. In this way, the string of batteries can be formed by the smaller-dimension solar cell I, which has a smaller dimension, lighter weight, and lower current with the same output voltage. Moreover, the string of batteries has a considerable output power and facilitates improving efficiency of the first photovoltaic component 4.

In an embodiment, the first photovoltaic component 4 can further include a first backplane 41, and both the first power transmission line 420 and the first cell component 43 can be fixed to the first backplane 41. Back of the second solar cell 2 can be attached to a side of the first backplane 41, front for receiving light thereof can be away from the side of the first backplane 41, and the first pass element 421 can be disposed on the other side of the first backplane 41. The first photovoltaic component 4 can further include structures such as a glass panel, a bezel, or an encapsulated film (not shown). The glass panel and the first backplane 41 can be disposed on opposite sides along a thickness direction of the first cell component 43. The glass panel can be disposed on an operation surface of the first cell component 43, and the glass panel can transmit light, so that the light can hit the second solar cell 2 and ensure the second solar cell 2 to generate electricity based on photovoltaic effect.

A dimension of an operation surface of the first photovoltaic component 4 can be approximately a dimension of the first backplane 41. Referring to FIG. 10, the length direction of the first photovoltaic component 4 can be along the Y-axis direction and the width direction thereof can be along the X-axis direction. In an embodiment, the length of the first photovoltaic component 4 denoted as B4 can be 2384 mm and the width of the first photovoltaic component 4 denoted as A4 can be 1134 mm.

The first photovoltaic component 4 provided in the present embodiment has power of about 580 W and efficiency of 21.454 %. In a comparative example, a battery queue of a photovoltaic component can include twelve half-chip cells, and a cell component of the photovoltaic component can include one hundred and forty-four half-chip cells. A dimension of the photovoltaic component can be about 2278 mm×1134 mm, the power of 550W, and the efficiency of 21.291%. The first photovoltaic component 4 has higher power than that of the photovoltaic component of the comparative example, and higher efficiency than that of the photovoltaic component of the comparative example. Moreover, the number of the solar cells I in the first photovoltaic component 4 can be fewer, which enables the first photovoltaic component 4 faster to manufacture. The dimension and current of the first photovoltaic component 4 can be suitable in the application environment such as a large photovoltaic plant, and the first photovoltaic component 4 has beneficial effect of high power.

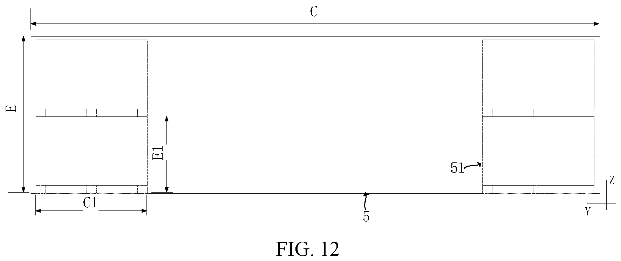

In other respects, the first photovoltaic component 4 can also have high utilization of transportation capacity. Referring to FIG. 12, a container 5 can often be used in international trade to transport the photovoltaic components, and the length of the container 5, that is, the dimension denoted as C along the Y-axis direction in FIG. 12, can be about 12.03 m, i.e., 12030 mm. A packaging box 51 is configured to pack the first photovoltaic component 4, and the dimension of the packaging box 51 denoted as C1 along the Y-axis direction can be slightly greater than the length of the first photovoltaic component 4 denoted as B4, i.e., slightly greater than 2384 mm. A total length of five first photovoltaic component 4 placed along the Y-axis direction can be 11920 mm, and the container 5 can still have 0.1 m of space remaining, which can be basically enough to reserve thickness of packaging materials of the packaging box 51. Gaps may remain between packing boxes 51. In an embodiment, a dimension of the container 5 denoted as E along the Z-axis direction can be greater than twice a dimension of the packing box 51 denoted as E1 along the Z axis direction.

The dimension of the photovoltaic component in the comparative example can be about 2278 mm × 1134 mm. Although the length thereof 2278 mm is less than the length B4 of the first photovoltaic component 4, only five photovoltaic components can be placed along the Y-axis direction in the container 5. The length of the first photovoltaic component 4 of the present embodiment can be flexibly adjusted by arranging the second solar cell 2 with the aspect ratio greater than 2 or less than 2. Therefore, the first photovoltaic component 4 can make full use of the transportation capacity, and total power of the photovoltaic component transported by the single container 5 can be enhanced. The first photovoltaic component 4 has advantages of flexibility in dimension, electrical parameter, and power, and can better meet practical requirements of transportation, installation, and application environment.

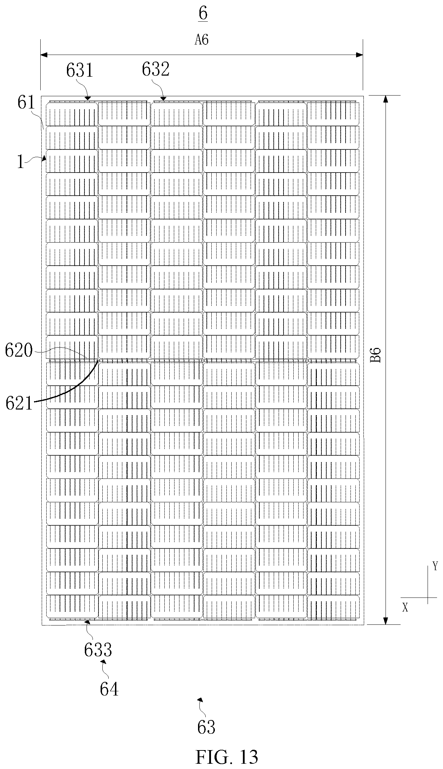

A photovoltaic component is provided in an embodiment of the present invention in FIG. 13. Referring to FIG. 13, a second photovoltaic component 6 provided in the embodiment of the present invention can include a second power transmission line 620 and a second cell component 63, and the second cell component 63 can be electrically connected to the second power transmission line 620 to ensure power supply capability of the second photovoltaic component 6.

In an embodiment, the solar cell I in the second photovoltaic component 6 can be the first solar cell 1 described above. Specifically, the extending direction of the gate line 200 of the first solar cell 1 can be along the width direction of the first solar cell 1. The first solar cells 1 of each of the battery queues in the second photovoltaic component 6 can be arranged along the extending direction of the gate line 200 and electrically connected in series, and each two of the battery queues can be electrically connected in series. The aspect ratio of the first solar cell 1 can be greater than 2, and less than 3 exemplarily.

In an embodiment, an array style of the solar cell I in the second cell component 63 can be the same as that of the solar cell I in the first cell component 43 described above. The second cell component 63 can also include one hundred and thirty-two first solar cells 1, the second power transmission line 620 can be located between two rows of the strings of batteries, and each of the strings of batteries can be connected in parallel with a second pass element 621 corresponding to the second power transmission line 620. For example, a first string of batteries 631 and a third string of batteries 633 of the second cell component 63 can be arranged in parallel along the Y-axis direction and connected in parallel to the same second pass element 621 to form a second battery module 64. The second power transmission line 620 can include a second bus bar connected to the second pass element 621, and the second bus bar can be connected to ends of a plurality of strings of batteries, so as to pool current to supply power to the outside world.

The first string of batteries 631 of the second cell component 63 and a second string of batteries 632 of the second cell component 63 can be arranged in parallel along the X-axis direction. In an embodiment, a circuit schematic of the second cell component 63 can be referred to FIG. 11. The second cell component 630 can supply power to external devices connected to the second photovoltaic component 6 via positive and negative terminals of the second power transmission line 620.

In an embodiment, the second photovoltaic component 6 can further include a second backplane 61, both the second power transmission line 620 and the second cell component 63 can be fixed to a side of the second backplane 61, and the second pass element 621 can be disposed on the other side of the second backplane 61. The second photovoltaic component 6 can further include structures such as a glass panel, a bezel, or an encapsulated film (not shown). The glass panel and the second backplane 61 can be disposed on opposite sides along a thickness direction of the second cell component 63, and the glass panel can be disposed on an operation surface of the second cell component 63.

In an embodiment, the battery queue of each string of batteries in the second cell component 63 can include eleven first solar cells 1, the second cell component 63 can include three second battery modules 64, and the cell array of the second cell component 63 can include one hundred and thirty-two first solar cells 1. In an embodiment, the length of the first solar cell 1 can be 182 mm and the width of the first solar cell 1 can be 77 mm. A dimension of an operation surface of the second photovoltaic component 6 can be approximately a dimension of the second backplane 61. Referring to FIG. 13, the length direction of the second photovoltaic component 6 can be along the Y-axis direction and the width direction thereof can be along the X-axis direction. In an embodiment, the length of the second photovoltaic component 6 denoted as B6 can be 1770 mm and the width of the second photovoltaic component 6 denoted as A6 can be 1134 mm.

In a comparative example, a cell array can be formed by half-chip cells acquired based on the cell sheet with a dimension of 182 mm×182 mm, and the cell array can be electrically connected to the pass element and the power transmission line to form a cell component. After arranging the half-chip cells of the cell component in the comparative example in the array style of the first solar cell 1 of the second cell component 63, the dimension of the photovoltaic component in the comparative example can be about 2094 mm×1134 mm. When an output voltage of the second photovoltaic component 6 provided in the embodiment of the present invention is the same as that of the photovoltaic component in the comparative example, the operation current of the second photovoltaic component 6 can be only 84.6% of that of the photovoltaic component in the comparative example, so that the second photovoltaic component 6 provided in the embodiment of the present invention has higher security.

Under a condition of the same output voltage, the photovoltaic component formed by the first solar cell provided in the embodiment of the present invention has a smaller dimension and lighter weight, which facilitates operations such as transportation and assembly when applied on rooftops and other mounting environments.

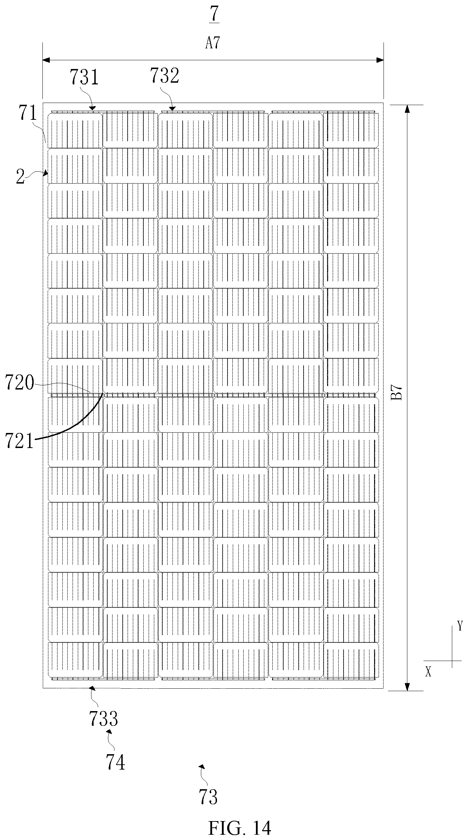

A photovoltaic component is provided in an embodiment of the present invention in FIG. 14. Referring to FIG. 14, a third photovoltaic component 7 provided in the embodiment of the present invention can include a third power transmission line 720 and a third cell component 73, and the third cell component 73 can be electrically connected to the third power transmission line 720 to ensure power supply capability of the third photovoltaic component 7.

In an embodiment, the third cell component 73 can include two rows of strings of batteries, and the two rows of strings of batteries can be disposed opposite sides of the third power transmission line 720. For example, a first string of batteries 731 of the third cell component and a third string of batteries 733 of the third cell component can be arranged in parallel along the Y-axis direction, and both the first string of batteries 731 and the third string of batteries 733 belong to a third battery module 74.

The first string of batteries 731 of the third cell component and a second string of batteries 732 of the third cell component can be arranged in parallel along the X-axis direction, and the second string of batteries 732 of the third cell component can be treated as a string of batteries in another third battery module 74. Each of the strings of batteries can be connected in parallel with a third pass element 721 corresponding to the third power transmission line 720, and the positive and negative terminals of the third power transmission line 720 can supply power to external devices connected to the third photovoltaic component 7. In an embodiment, the solar cell I in the third photovoltaic component 7 can be the second solar cell 2 described above. Specifically, the extending direction of the gate line 200 of the second solar cell 2 can be along the width direction of the second solar cell 2. The second solar cell 2 of each string of batteries in the third photovoltaic component 7 can be arranged along the extending direction of the gate line 200 and connected in series. The aspect ratio of the second solar cell 2 can be less than 2, and greater than 3/2 exemplarily. The third power transmission line 720 can include a third bus bar connected to the third pass element 721, and the third bus bar can be connected to ends of a plurality of strings of batteries, so as to pool current to supply power to the outside world.

In some embodiments, referring to FIG. 14, the third cell component 73 can include three battery modules 50, each battery module 50 can include two strings of batteries connected in parallel, each string of batteries can include two battery queues arranged in parallel, and each battery queue can include eight second solar cells 2 arranged in parallel. The cell array of the third cell component 73 can include ninety-six second solar cells 2.

In an embodiment, the third photovoltaic component 7 can further include a third backplane 71, and both the third power transmission line 720 and the third cell component 73 can be fixed to the third backplane 71. The third photovoltaic component 7 can further include structures such as a glass panel, a bezel, or an encapsulated film (not shown). The glass panel and the third backplane 71 can be disposed on opposite sides along a thickness direction of the third cell component 73, and the glass panel can be disposed on an operation surface of the third cell component 73.

In an embodiment, the length of the second solar cell 2 can be 182 mm and the width of the second solar cell 2 can be 105 mm. A dimension of the operation surface of the third photovoltaic component 7 can be approximately a dimension of the third backplane 71. Referring to FIG. 14, the length direction of the third photovoltaic component 7 can be along the Y-axis direction and the width direction thereof can be along the X-axis direction. In an embodiment, the length of the third photovoltaic component 7 denoted as B7 can be 1770 mm, and the width of the third photovoltaic component 7 denoted as A7 can be 1134 mm. A peripheral dimension of the third photovoltaic component 7 can be the same as that of the second photovoltaic component 6 including one hundred and thirty-two first solar cells 1, so that the third photovoltaic component 7 and the second photovoltaic component 6 can adapt to the same packaging process, consumables, and accessories. For example, the third backplane 71 and the second backplane 61 can be the same one, and the glass panel, the bezel, or the encapsulated film etc. of the third photovoltaic component 7 can be the same as that of the second photovoltaic component 6 respectively. The photovoltaic component provided in the embodiment of the present invention has less impact on the production lines, thus simplifying production process and improving production efficiency.

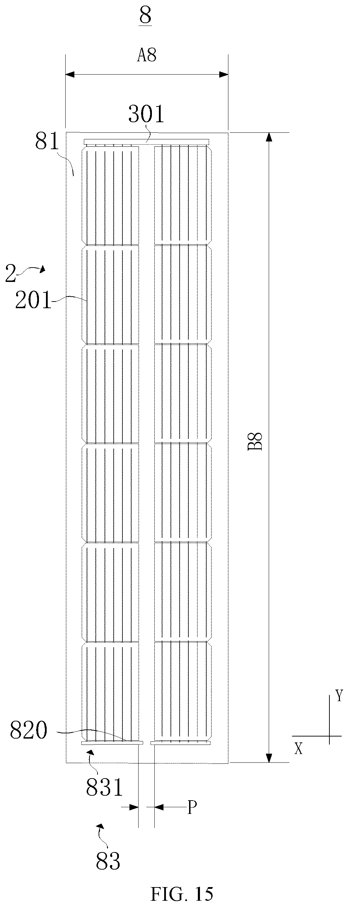

A photovoltaic component is provided in an embodiment of the present invention in FIG. 15. Referring to FIG. 15, a fourth photovoltaic component 8 provided in the embodiment of the present invention can include a fourth cell component 83. The fourth cell component 83 can include a string of batteries, i.e., a string of batteries 831 of the fourth cell component. The fourth cell component 83 can be electrically connected to a fourth power transmission line 820 to ensure power supply of the fourth photovoltaic component 8.

In an embodiment, the solar cell I in the fourth photovoltaic component 8 can be the second solar cell 2 described above. Specifically, the direction of the gate line 200 of the second solar cell 2, i.e., the extending direction of the second gate line 201 can be along the length direction of the second solar cell 2, and the second solar cell 2 of each battery queue in the fourth photovoltaic component 8 can be arranged along the direction of the gate line 200 and electrically connected in series. The aspect ratio of the second solar cell 2 can be less than 2, and greater than 3/2 exemplarily.

The string of batteries 831 of the fourth cell component can include two battery queues arranged in parallel, which can be disposed opposite along the Y-axis direction. The fourth photovoltaic component 8 can include a conductive connection wire 301 to concatenate the two battery queues, and a cathode and an anode of the string of batteries 831 of the fourth cell component can be disposed on a side away from the conductive connection wire 301.

In some embodiments, referring to FIG. 15, a battery module of the fourth cell component 83 can include a string of batteries, the string of batteries 831 of the fourth cell component can include two battery queues arranged in parallel, and each battery queue can include six second solar cells 2 arranged in parallel. A cell array of the fourth cell component 83 can include twelve second solar cells 2.

In an embodiment, the fourth photovoltaic component can further include a fourth backplane 81, the fourth cell component 83 can be fixed to a side of the fourth backplane 81, and the pass element 40 can be disposed on the other side of the fourth backplane 81. The fourth photovoltaic component 8 can further include structures such as a glass panel, a bezel, or an encapsulated film (not shown). The glass panel and the fourth backplane 81 can be disposed on opposite sides along a thickness direction of the fourth cell component 83, and the glass panel can be disposed on an operation surface of the fourth cell component 83.

In an embodiment, the length of the second solar cell 2 can be 182 mm and the width of the second solar cell 2 can be 105 mm. A dimension of the operation surface of the fourth photovoltaic component 8 can be approximately a dimension of the fourth backplane 81. Referring to FIG. 15, the length direction of the fourth photovoltaic component 8 can be along the Y-axis direction and the width direction thereof can be along the X-axis direction. In an embodiment, the length of the fourth photovoltaic component 8 denoted as B8 can be less than or equal to 1770 mm, the width of the fourth photovoltaic component 8 denoted as A8 can be less than or equal to 300 mm, and an area of the operation surface of the fourth cell component 83 can occupy about 65% of an area of the fourth backplane 81.

The second solar cell 2 can be arranged along the length direction of the second solar cell 2, so that the fourth photovoltaic component 8 provided in the present embodiment can have an overall narrow form. The fourth photovoltaic component 8 provided in the present embodiment can be suitable to mount into a building, the building can be equipped with a louver, a roof tile, or a shed roof with a light transmission requirement, and these locations with the light transmission requirement can be mounted or configured with the fourth photovoltaic component 8. The fourth photovoltaic component 8 can be integrated as a part of the building, and the fourth photovoltaic component 8 can be adaptable and configured to generate solar power.

In a comparative example, only twelve half-chip cells can be mounted in a narrow mounting space of 1170 mm × 300 mm when the half-chip cells of 182mm × 91mm are used. In the embodiment of the present invention, the fourth photovoltaic component 8 can include the second solar cell 2 with an aspect ratio less than 2 and a larger area, so as to achieve a higher area coverage. Moreover, the fourth photovoltaic component 8 can have greater generation power than that of the photovoltaic component of the comparative example.

In an embodiment, the string of batteries 831 of the fourth cell component can include two battery queues spaced apart. A thin gap can be formed between the two battery queues spaced apart to achieve a better light transmission. The gap denoted as P can be approximately 30 mm, and a distance between the two battery queues and a boundary of the mounting space along the width direction of the two battery queues can also be approximately 30 mm.

The technical features of the above-described embodiments may be combined in any combination. For the sake of brevity of description, not all possible combinations of the technical features in the above embodiments are described. However, as long as there is no contradiction between the combinations of these technical features, all should be considered as within the scope of this invention.

Various forms of the process described above can be used, and steps can also be reordered, added, or deleted. The steps documented in the present embodiment can be performed in parallel, sequentially, or in a different order, as long as the desired result of the technical solution provided by this embodiment is achieved, and this invention is not limited herein.

The above-described embodiments are merely illustrative of several embodiments of the present invention, and the description thereof is relatively specific and detailed, but is not to be construed as limiting the scope of the invention. It should be noted that a number of variations and modifications may be made by those skilled in the art without departing from the spirit and scope of the invention, which belong to the scope of the claimed invention. Therefore, the scope of the invention should be determined by the appended claims.

## Claims

1. A method of manufacturing a solar cell, **characterized by** comprising:
acquiring a solar cell by dividing a cell sheet, wherein an aspect ratio of the solar cell is greater than 2 or less than 2, and a length of the solar cell is the same as a dimension of the cell sheet along a dividing direction.

2. The method of claim 1, wherein the acquiring the solar cell by dividing the cell sheet comprises:
acquiring a first solar cell, wherein a ratio of a width of the first solar cell to a length of the first solar cell is greater than 1/3 and less than 1/2.

3. The method of claim 2, wherein the dimension of the cell sheet is 182 mm×182 mm, and the acquiring the first solar cell comprises acquiring the first solar cell with a width of 77±1 mm.

4. The method of claim 1, wherein the acquiring the solar cell by dividing the cell sheet comprises:
acquiring a second solar cell, wherein a ratio of a width of the second solar cell to a length of the second solar cell is greater than 1/2 and less than 2/3.

5. The method of claim 4, wherein the dimension of the cell sheet is 182 mm×182 mm, and the acquiring the second solar cell comprises acquiring the second solar cell with a width of 105±1 mm.

6. The method of any one of claims 1 to 5, wherein the cell sheet comprises a semiconductor structure and a gate line in ohmic contact with the semiconductor structure, and the dividing the cell sheet comprises:
dividing the cell sheet along an extending direction of the gate line, or along a direction perpendicular to the extending direction of the gate line.

7. A solar cell, **characterized in that** a ratio of a width of the solar cell to a length of the solar cell is greater than 1/2 and less than 1/2.

8. The solar cell of claim 7, wherein the width of the solar cell denoted as L and the length of the solar cell denoted as D meet the following formula: 1/3<L/D<2/3, and L/D≠1/2.

9. The solar cell of claim 8, wherein the length of the solar cell is 182 mm, and the width of the solar cell is 77±1 mm or 105±1 mm.

10. A photovoltaic component, **characterized by** comprising at least one string of batteries, which comprises at least two solar cells connected in series, wherein a ratio of a width of each of the at least two solar cells to a length of corresponding one of the at least two solar cells is greater than 1/2 or less than 1/2.

11. The photovoltaic component of claim 10, wherein the ratio of the width of each of the at least two solar cells to the length of corresponding one of the at least two solar cells is greater than 1/3 and less than 1/2.

12. The photovoltaic component of claim 11, wherein the length of each of the at least two solar cells is 182 mm, the width of corresponding one of the at least two solar cells is 77±1 mm, a direction of a gate line of each of the at least two solar cells is along a direction of the width of corresponding one of the at least two solar cells, the at least one string of batteries comprises at least two battery queues arranged in parallel, and each of the at least two battery queues comprises at least two solar cells arranged along the direction of the gate line.

13. The photovoltaic component of claim 10, wherein the ratio of the width of each of the at least two solar cells to the length of corresponding one of the at least two solar cells is greater than 1/2 and less than 2/3.

14. The photovoltaic component of claim 13, wherein the length of each of the at least two solar cells is 182 mm, the width of corresponding one of the at least two solar cells is 105±1 mm, a direction of a gate line of each of the at least two solar cells is along a direction of the width of corresponding one of the at least two solar cells, the at least one string of batteries comprises at least two battery queues arranged in parallel, and each of the at least two battery queues comprises at least two solar cells arranged along the direction of the gate line; or
the length of each of the at least two solar cells is 182 mm, the width of corresponding one of the at least two solar cells is 105±1 mm, the direction of the gate line of each of the at least two solar cells is along a direction of the length of corresponding one of the at least two solar cells, the at least one string of batteries comprises at least two battery queues arranged in parallel and spaced apart, each of the at least two battery queues comprises six solar cells, and the photovoltaic component comprises one string of batteries.

15. The photovoltaic component of claim 12 or claim 14, wherein each of the at least two battery queues comprises eleven solar cells, the at least one string of batteries comprises two battery queues, two strings of batteries connected in parallel with each other are defined as a battery module, and the photovoltaic component comprises three battery modules arranged in parallel and connected in series; or
each of the at least two battery queues comprises eight solar cells, the at least one string of batteries comprises two battery queues, two strings of batteries connected in parallel with each other are defined as a battery module, and the photovoltaic component comprises three battery modules arranged in parallel and connected in series.
